# FASCICULE DE BREVET EUROPEEN

(11) **EP 2 714 584 B1**
(45) Date de publication et mention de la délivrance du brevet: **06.07.2016**
(21) Numéro de dépôt: 12731083.7
(22) Date de dépôt: 29.05.2012
(51) Int. Cl.: B81C 99/00, H01L 23/498

(54) **PROCEDE POUR LA REALISATION DE SUPPORTS FONCTIONNELS SOUPLES**
VERFAHREN ZUR HERSTELLUNG FLEXIBLER FUNKTIONELLER SUBSTRATE
METHOD FOR MANUFACTURING FLEXIBLE FUNCTIONAL SUBSTRATES

(30) Priorité: 30.05.2011 FR 1154712
(43) Date de publication de la demande: 09.04.2014
(73) Titulaire: Université Paris-Sud 11, 91400 Orsay (FR); Centre National de la Recherche Scientifique, 75016 Paris (FR)
(72) Inventeur: HAMOUDA, Frédéric, F-91600 Savigny Sur Orge (FR); AASSIME, Abdelhanin, 91130 Monthlery (FR)
(74) Mandataire: Pontet Allano & Associes
(86) Numéro de dépôt international: PCT/FR2012/051198
(87) Numéro de publication internationale: WO 2012/164216

(56) Documents cités:
- FR-A1- 2 877 142
- US-A1- 2003 157 783
- US-A1- 2006 231 288

## Description

La présente invention concerne un procédé pour la réalisation de supports fonctionnels souples. Elle concerne également des utilisations de tels supports.

Le domaine de l'invention est le domaine des supports fonctionnels souples pour des éléments ou objets fonctionnels et, plus particulièrement, le domaine des supports fonctionnels pour des objets ou éléments fonctionnels de dimensions micrométriques ou sub-micrométriques.

Les objets micrométriques ou nanométriques sont de plus en plus utilisés dans de nombreux domaines allant de l'automobile au domaine du cosmétique en passant par le domaine de la médecine pour des applications variées par exemple de type électronique ou photonique.

### Etat de la technique

Dans certaines catégories de supports souples tels que le kapton, les supports souples fonctionnels comprenant des éléments fonctionnels sont actuellement obtenus par des techniques standard. Par exemple, les éléments fonctionnels sont fabriqués sur les supports souples en utilisant des techniques ascendantes (« bottom-up » en anglais) ou des techniques descendantes (« top-down » anglais).

Cependant, les supports souples, présentant des propriétés physico-chimiques différentes des supports rigides, la réalisation d'éléments fonctionnels sur ces supports nécessite des étapes technologiques supplémentaires ou modifiées pour cet objectif.

Certaines étapes de fabrication actuelles d'éléments fonctionnels ne peuvent être réalisées sur les supports souples en raison de certaines de leurs propriétés physico-chimiques. Par exemple, le faible module d'Young ou la nature isolante des supports souples constituent un verrou technologique pour la réalisation de supports fonctionnels souple pour des éléments fonctionnels de dimensions micrométriques ou sub-micrométriques. Le document US 2003/157783 A1 décrit un procédé qui comprend le dépôt d'une couche sacrificielle sur un support rigide, la réalisation d'un élément fonctionnel sur la couche sacrificielle et son transfert sur un support souple par élimination de la couche sacrificielle.

Un but de la présente invention est de remédier à ces inconvénients.

Un autre but de l'invention est de proposer un procédé plus simple, plus pratique, plus rapide et moins onéreux à mettre en oeuvre pour la réalisation de supports fonctionnels souples.

Enfin, un autre but de l'invention est de proposer un procédé permettant la réalisation de supports fonctionnels comprenant des éléments fonctionnels de dimensions micrométriques ou sub-micrométriques.

### Exposé de l'invention

L'invention propose d'atteindre au moins l'un de ces buts par un procédé pour la réalisation d'un support souple comprenant au moins un élément fonctionnel de dimensions micrométriques ou sub-micrométriques, caractérisé en ce qu'il comprend les étapes suivantes :
- dépôt d'une couche sacrificielle sur un support rigide, dit maître,
- réalisation dudit élément fonctionnel sur ladite couche sacrificielle,
- transfert dudit élément fonctionnel sur un support souple .

L'étape de transfert comprend les étapes suivantes:
- réalisation du support souple sur ladite couche sacrificielle,
- élimination de ladite couche sacrificielle.

Selon l'invention la couche sacrificielle comprend un oxyde de molybdène.

Par support souple on entend dans la présente demande un support pouvant se trouver à l'état liquide et dont le passage à l'état solide souple peut être contrôlé, tel que par exemple les silicones à base de polysiloxanes.

L'invention propose donc de fabriquer les éléments fonctionnels sur un support maître rigide et de les transférer sur le support souple après fabrication. Ainsi, n'ayant pas à réaliser les éléments fonctionnels directement sur le support souple l'invention permet de contourner les étapes technologiques qui sont difficiles voire impossibles à réaliser sur un support souple ou de réaliser des étapes supplémentaires pour fabriquer les éléments fonctionnels directement sur le support souple. Le procédé selon l'invention est donc plus simple, plus pratique, plus rapide et moins onéreux à mettre en oeuvre pour la réalisation de supports fonctionnels souples que les procédés de l'état de la technique.

L'invention permet également de contourner les verrous technologiques lors de la réalisation d'éléments fonctionnels de dimensions micrométriques ou nanométriques sur les supports souples et permet ainsi d'obtenir des supports souples dotés de tels éléments fonctionnels.

Dans la présente demande :
- « élément fonctionnel » désigne un élément ayant une fonction associée, dans tous domaines et notamment dans le domaine de l'électronique, la photonique, la cosmétique, le médical, l'automobile, etc. ; et
- « support fonctionnel » désigne un support comportant un tel élément fonctionnel prévu pour réaliser sa fonction sur ce support ou sur un autre support après transfert de cet élément sur cet autre support.

Avantageusement, l'étape de transfert de l'élément fonctionnel sur le support souple peut comprendre une étape lors de laquelle un matériau destiné à former le support souple est coulé sur la face du support rigide comportant l'élément fonctionnel, par exemple dans le cadre d'une étape de moulage.

Ce matériau peut préalablement être rendu suffisamment visqueux pour épouser la face du support comportant l'élément fonctionnel de sorte que le matériau entoure parfaitement chaque élément fonctionnel présent sur cette face du support rigide, et plus précisément sur la couche sacrificielle.

Après l'étape de coulage, et plus particulièrement après une étape de moulage, le procédé selon l'invention peut comprendre une étape lors de laquelle le matériau coulé sur le support rigide est durci.

Dans le cas où, le support souple est du silicone, le durcissement est réalisé par traitement thermique, par exemple par un recuit à une température de 70°C pendant une durée supérieure ou égale à deux heures.

Le durcissement du matériau coulé peut également être réalisé grâce à un agent réticulant incorporé audit matériau coulé avant l'étape de coulage et plus particulièrement avant l'étape de moulage.

L'agent réticulant peut être un agent dont la fonction est activée par un moyen d'activation, tel que par exemple un rayonnement, un courant électrique et/ou magnétique, un agent chimique, ou une combinaison quelconque de ces moyens.

Dans le cas où le support souple est en silicone un kit RTV 615 fourni par ELECO PRODUITS peut être utilisé pour le durcissement du silicone.

Avantageusement, le procédé selon l'invention peut comprendre une étape d'ajout d'un diluant dans le matériau destiné à former le support souple avant le coulage, et plus particulièrement avant l'étape de moulage, pour diminuer la viscosité de ce matériau. Ainsi, une plus grande précision de moulage peut être obtenue, par exemple, pour la réalisation d'éléments présentant des cavités nanométriques, tels que des cavités de dimensions inférieures ou égales à 100nm.

Le support souple peut être transparent de sorte à autoriser une observation visuelle au travers du support.

Par ailleurs, le support souple peut être réalisé en un matériau biocompatible. Selon un exemple de réalisation non limitatif, le support souple peut être réalisé en un matériau choisi dans la famille des polydiméthylsiloxanes.

Selon un exemple de réalisation préféré, le matériau dans lequel est réalisé le support souple comprend du silicone, ou est du silicone.

La couche sacrificielle comprend un oxyde de molybdène.

L'oxyde de molybdène présente l'avantage de pouvoir être éliminé par l'eau à 80°C. Ainsi, l'étape d'élimination de la couche sacrificielle est plus facile, moins agressive à réaliser et moins polluante et plus écologique.

Par ailleurs, l'oxyde de molybdène présente une température de fusion de 750°C et une température de sublimation d'environ 400°C. Cette température de sublimation est plus grande que la température de sublimation des autres matériaux éliminables à l'eau. Ainsi, une couche sacrificielle réalisée en oxyde de molybdène présente moins de limitation vis-à-vis de la température pour la réalisation d'éléments fonctionnels par des techniques standard actuellement connues dont certaines comprennent des étapes réalisées à des températures élevées.

Selon un exemple de réalisation préféré non limitatif, la couche sacrificielle est de l'oxyde de molybdène, par exemple MoO, MoO₂ ou MoO₃.

Avantageusement, l'étape d'élimination de la couche sacrificielle peut être réalisée avec une solution comprenant de l'eau et/ou du peroxyde d'hydrogène.

Le procédé selon l'invention peut en outre comprendre un ajout d'un agent compatible avec le matériau utilisé pour réaliser la couche sacrificielle afin d'augmenter la température de sublimation de la couche sacrificielle.

Un tel matériau peut être du silicium, le matériau utilisé pour réaliser le support rigide ou une combinaison de ces matériaux.

Le support rigide ou le support maître peut être réalisé en un ou plusieurs matériaux choisis parmi le silicium, le verre ou tout autre support rigide compatible avec les méthodes de fabrication en micro- et nano-technologie.

L'étape de réalisation de l'élément fonctionnel peut comprendre une réalisation dudit élément fonctionnel sur la couche sacrificielle du support rigide par une technique descendante « top-down » ou ascendante (« bottom-up » en anglais) ou tout autre technique connue de l'art antérieur et convenant à la réalisation d'éléments fonctionnels sur un support rigide dotée d'une couche sacrificielle.

De telles techniques peuvent comprendre les techniques de lithographie, par exemple de lithographie UV pour « UltraViolet », NIL pour « Lithographie par Nano-Impression », lithographie E-Beam pour « Electronique Beam », les techniques de gravure, de dépôt, de liftoff, etc.

Dans une version particulièrement avantageuse du procédé selon l'invention, l'étape de réalisation de l'élément fonctionnel peut comprendre une réalisation sur ledit élément fonctionnel d'une forme/partie, prévue pour être entourée par le support souple, et présentant avec la couche sacrificielle et/ou le support rigide un angle inférieure ou égale 90° lorsque ledit objet est déposé sur ladite couche sacrificielle.

Autrement dit, l'étape de réalisation de l'élément fonctionnel peut comprendre une réalisation sur ledit élément fonctionnel d'une partie formant une contre dépouille s'opposant à l'extraction dudit élément dudit support souple dans la direction perpendiculaire au plan formé par le support souple, et dans un sens ou dans l'autre.

L'élément fonctionnel comporte alors une première partie d'au moins une dimension latérale plus faible qu'une deuxième partie, ladite première partie étant plus proche du support rigide que ladite deuxième partie lorsque ledit élément est déposé sur le support rigide, les dimensions latérales dudit élément étant les dimensions dans les directions parallèles au plan dudit support rigide.

Ainsi, l'ancrage mécanique de l'élément fonctionnel dans le support souple est augmenté, ce qui évite le détachement involontaire de l'élément fonctionnel du support souple, par exemple lors de la manipulation du support souple.

Le support souple peut être utilisé dans les domaines de la médecine et/ou de la biologie pour la réalisation d'implants, de dispositifs dits « Laboratoire d'étude biologique intégré sur une carte à puce » (« Lab on Chip » en anglais) ou des organes intelligents.

Le support souple peut également être utilisé dans l'industrie automobile ou aéronautique.

Le support souple peut également être utilisé dans le domaine de la recherche et développement pour réaliser des dispositifs micro fluidiques, électroniques et/ou photonique.

### Liste des figures

D'autres particularités et avantages de l'invention ressortiront de la description détaillée d'un mode de mise en oeuvre nullement limitatif, et des dessins annexés sur lesquels :
- la FIGURE 1 est une représentation sous la forme d'un diagramme d'une première version d'un procédé selon l'invention ;
- la FIGURE 2 est une représentation sous la forme d'un diagramme d'une deuxième version d'un procédé selon l'invention ;
- la FIGURE 3 est une représentation schématique de la réalisation d'un support souple conformément en procédé selon l'invention ;
- la FIGURE 4 est un exemple d'un support souple réalisé avec le procédé selon l'invention ; et
- la FIGURE 5 représente le résultat obtenu avec le support souple fonctionnel de la figure 4.

Sur les figures un élément commun à plusieurs figures conserve la même référence.

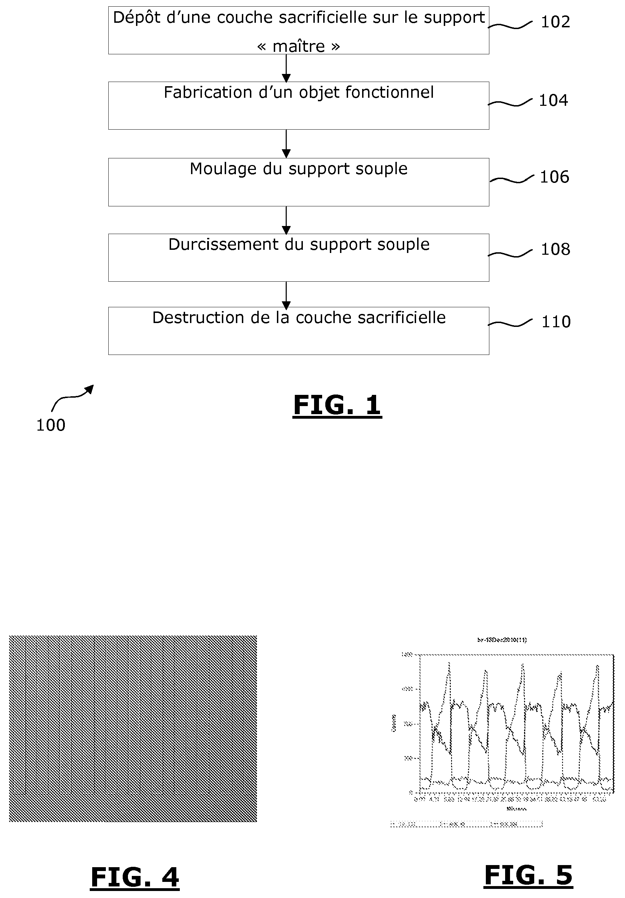

La FIGURE 1 est une représentation schématique d'une première version d'un procédé de réalisation d'un support souple selon l'invention.

Le procédé 100 représenté sur la figure 1 comprend une première étape 102 de dépôt d'une couche sacrificielle, en trioxyde molybdène, sur un support rigide, dit maître, en silicium.

Cette étape 102 est suivie d'une étape de fabrication/réalisation/dépôt d'un ou plusieurs éléments fonctionnels sur le couche sacrificielle par des techniques connues de type « bottom-up » ou « top-down ».

Une fois que les éléments fonctionnels sont réalisés sur la couche sacrificielle, le silicone pour réaliser le support souple est moulé, à l'étape 106, sur la couche sacrificielle.

A l'étape 108 le matériau moulé est durci pour obtenir le support souple.

A l'étape 110 la couche sacrificielle d'oxyde de molybdène est détruite pour séparer le support souple comprenant les éléments fonctionnels du support maître rigide.

Ainsi, un support souple comprenant des éléments fonctionnels est obtenu.

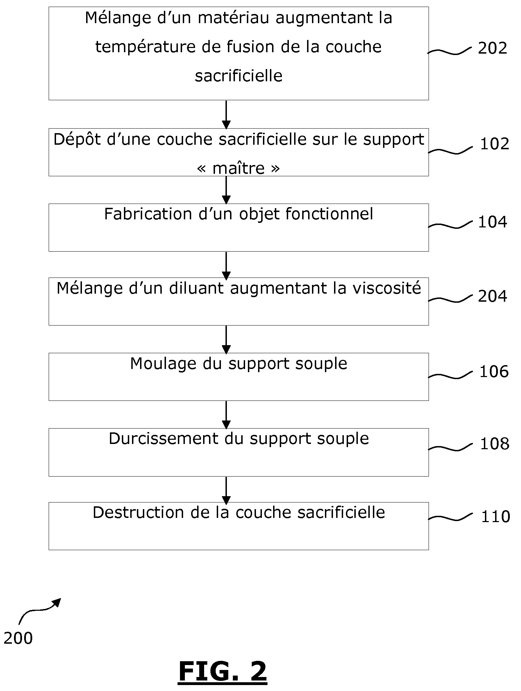

La FIGURE 2 est une représentation schématique d'une deuxième version d'un procédé de réalisation d'un support souple selon l'invention.

Le procédé 200 représenté sur la figure 1 comprend toutes les étapes du procédé 100 représenté en figure 1.

Le procédé 200 comprend en outre une étape préliminaire 202 lors de laquelle un matériau augmentant la température de fusion de l'oxyde de molybdène utilisé pour former la couche sacrificielle est mélangé à l'oxyde de molybdène. Ce matériau peut être le matériau utilisé pour réaliser le support rigide, tel que le silicium ou le verre ou tout autre matériau compatible avec l'oxyde de molybdène.

Dans un mode de réalisation préféré, les étapes 102 et 202 peuvent être réalisées en même temps

Le procédé 200 comprend en outre, avant l'étape 106 de moulage du support souple sur la couche sacrificielle, une étape 204 d'ajout au matériau composant le support souple, c'est-à-dire le silicone, d'un agent diluant diminuant la viscosité de ce matériau, tel que par exemple le toluène.

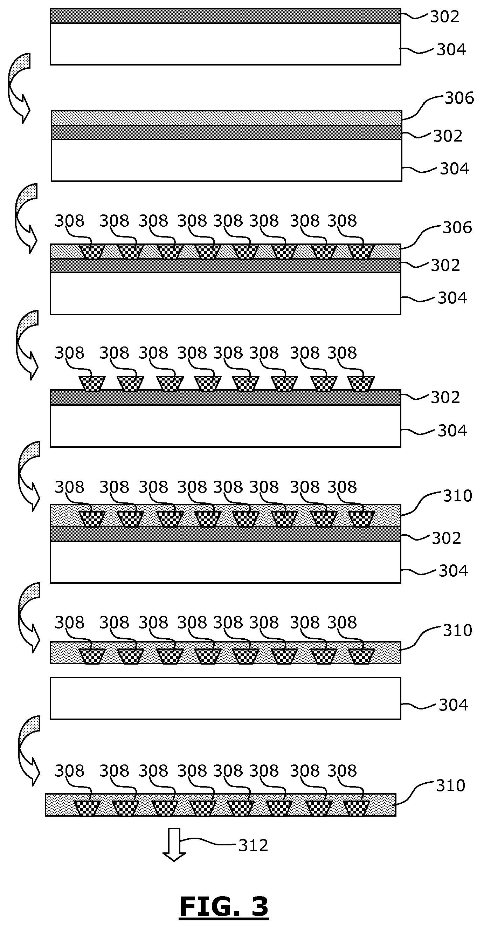

La FIGURE 3 est une représentation schématique de la réalisation d'un support souple conformément au procédé selon l'invention selon une vue en coupe.

Une couche sacrificielle 302 est déposée sur un support rigide 304. Une couche 306 de résine est déposée sur la couche sacrificielle 302 pour la réalisation d'éléments fonctionnels 308. Les éléments fonctionnels 308 sont réalisés dans la couche de résine 306, puis la couche de résine 306 est éliminée. Après élimination de la couche de résine 306, il reste seulement les éléments fonctionnels 308 sur la couche sacrificielle 302.

Une couche 310 de matériau visqueux destiné à former le support souple est alors moulée sur les éléments fonctionnels 308 et la couche sacrificielle 302. Après le moulage, la couche 310 de matériau visqueux est durcie, par exemple par l'intermédiaire d'un agent réticulant, pour former le support souple.

La couche sacrificielle 302 est alors éliminée avec un agent d'élimination adéquat. A ce moment-là, le support souple 310 est désolidarisé du support rigide 304 et les éléments fonctionnels sont « emprisonnés » dans le support souple 310 et un support souple fonctionnel 310 est obtenu.

Tel que représenté sur la figure 3, chaque élément fonctionnel 308 présente une forme en trapèze de sorte que chaque élément 308 présente une forme en contre dépouille s'opposant à l'extraction de l'élément 308 hors du support souple 310 dans la direction perpendiculaire au plan formé par le support souple 310 et dans le sens allant vers le support rigide 304, sens matérialisé par le flèche 312.

Bien que tous les éléments fonctionnels représentés sur la figure 3 soient en forme de trapèze, d'autres formes présentant une partie en contre dépouille conviennent également.

La FIGURE 4 et une représentation d'un exemple d'un support souple fonctionnel réalisé avec le procédé selon l'invention selon une vue de dessus.

Les lignes sur la figure 4 représentent des lignes en aluminium de 500nm d'épaisseur.

La FIGURE 5 est une représentation d'un exemple de résultat obtenu avec le support souple fonctionnel de la figure 4

Cette figure représente les résultats de l'analyse EDS (de l'anglais « Energy Dispersion Spectroscopy ») d'une partie l'image de la figure 3 montrant la présence des lignes d'aluminium dans le substrat souple. La raie K est détectée pour les éléments suivant : l'aluminium, l'oxygène et le silicium. L'axe des coordonnées représente le nombre de couts mesuré.

Bien sûr, l'invention n'est pas limitée aux exemples qui viennent d'être décrits et de nombreux aménagements peuvent être apportés à ces exemples sans sortir du cadre de l'invention.

## Revendications

1. Procédé (100, 200) pour la réalisation d'un support souple (310) comprenant au moins un élément fonctionnel (308) de dimensions micrométriques ou sub-micrométriques, ledit procédé comprenant les étapes suivantes :
- dépôt (102) d'une couche sacrificielle (302) sur un support rigide (304), dit maître,
- réalisation (104) dudit élément fonctionnel (308) sur ladite couche sacrificielle (302),
- transfert (106, 108, 110) dudit élément fonctionnel (308) sur un support souple (310), ladite étape de transfert comprenant les étapes suivantes :
o réalisation du support souple sur ladite couche sacrificielle, et
o élimination (110) de ladite couche sacrificielle (302) ;
**caractérisé en ce que** la couche sacrificielle (302) comprend un oxyde de molybdène.

2. Procédé selon la revendication 1, **caractérisé en ce que** l'étape de réalisation du support souple comprend une étape (106) lors de laquelle un matériau destiné à former le support souple (310) est coulé sur la face du support rigide (304) comportant l'élément fonctionnel (308).

3. Procédé selon la revendication 2, **caractérisé en ce qu'**il comprend une étape (108) de durcissement du matériau coulé par un agent réticulant incorporé audit matériau coulé.

4. Procédé selon l'une quelconque des revendications 2 ou 3, **caractérisé en ce qu'**il comprend un ajout (204) d'un diluant dans le matériau destiné à former le support souple (310) avant le coulage.

5. Procédé selon l'une quelconque des revendications précédentes, **caractérisé en ce que** le matériau dans lequel est réalisé le support souple (310) comprend du silicone.

6. Procédé selon l'une quelconque des revendications précédentes, **caractérisé en ce que** la couche sacrificielle (302) est de l'oxyde de molybdène.

7. Procédé selon l'une quelconque des revendications précédentes, **caractérisé en ce que** l'étape d'élimination de la couche sacrificielle (302) est réalisée avec une solution comprenant de l'eau et/ou du peroxyde d'hydrogène.

8. Procédé selon l'une quelconque des revendications précédentes, **caractérisé en ce qu'**il comprend un ajout (202) d'un matériau compatible avec l'oxyde de molybdène pour augmenter la température de fusion de la couche sacrificielle (302).

9. Procédé selon l'une quelconque des revendications précédentes, **caractérisé en ce que** le support rigide (304) est réalisé un ou plusieurs matériaux choisis parmi le silicium ou le verre.

10. Procédé selon l'une quelconque des revendications précédentes, **caractérisé en ce que** l'étape de réalisation de l'élément fonctionnel comprend une réalisation dudit élément fonctionnel (308) sur la couche sacrificielle (302) du support rigide (304) par une technique descendante (« top-down » en anglais) ou ascendante (« bottom-up » en anglais).

11. Procédé selon la revendication 10, **caractérisé en ce que** l'étape de réalisation de l'élément fonctionnel (308) comprend une réalisation sur ledit élément fonctionnel d'une forme/partie, prévue pour être entourée par le support souple (310), et présentant avec la couche sacrificielle (302) et/ou le support rigide (304) un angle inférieure ou égale 90° lorsque ledit élément est déposé sur ladite couche sacrificielle (302).

## Patentansprüche

1. Verfahren (100, 200) zur Herstellung eines flexiblen Trägers (310) mit mindestens einem Funktionselement (308) mit Abmessungen im Mikrometer- bzw. Submikrometerbereich, wobei das Verfahren folgende Schritte umfasst:
- Aufbringen (102) einer Opferschicht (302) auf einen starren Träger (304), den sogenannten Masterträger,
- Herstellung (104) des Funktionselements (308) auf der Opferschicht (302),
- Transfer (106, 108, 110) des Funktionselements (308) auf einen flexiblen Träger (310), wobei dieser Transferschritt folgende Schritte umfasst:
o Herstellung des flexiblen Trägers auf der Opferschicht, und
o Entfernung (110) dieser Opferschicht (302);
**dadurch gekennzeichnet, dass** die Opferschicht (302) ein Molybdaenoxid enthält.

2. Verfahren nach Anspruch 1, **dadurch gekennzeichnet, dass** der Schritt für die Herstellung des flexiblen Trägers einen Schritt (106) umfasst, in welchem ein Material zur Bildung des flexiblen Trägers (310) auf die Seite des starren Trägers (304) gegossen wird, an welcher das Funktionselement (308) angeordnet ist.

3. Verfahren nach Anspruch 2, **dadurch gekennzeichnet, dass** es einen Schritt (108) für die Erhärtung des gegossenen Materials durch ein in diesem gegossenen Material beigemischtes Vernetzungsmittel umfasst.

4. Verfahren nach einem der Ansprüche 2 oder 3, **dadurch gekennzeichnet, dass** es eine Zugabe (204) eines Verdünnungsmittels in das Material zur Bildung des flexiblen Trägers (310) vor dem Gießen umfasst.

5. Verfahren nach einem der vorhergehenden Ansprüche, **dadurch gekennzeichnet, dass** das Material, aus welchem der flexible Träger (310) hergestellt wird, Silikon enthält.

6. Verfahren nach einem der vorhergehenden Ansprüche, **dadurch gekennzeichnet, dass** es sich bei der Opferschicht (302) um Molybdaenoxid handelt.

7. Verfahren nach einem der vorhergehenden Ansprüche, **dadurch gekennzeichnet, dass** der Schritt für die Entfernung der Opferschicht (302) mit einer wasser- und/oder wasserstoffperoxidhaltigen Lösung ausgeführt ist.

8. Verfahren nach einem der vorhergehenden Ansprüche, **dadurch gekennzeichnet, dass** es eine Zugabe (202) eines mit Molybdaenoxid kompatiblen Materials zur Steigerung der Schmelztemperatur der Opferschicht (302) umfasst.

9. Verfahren nach einem der vorhergehenden Ansprüche, **dadurch gekennzeichnet, dass** der starre Träger (304) aus einem oder mehreren, zwischen Silizium oder Glas gewählten Materialien hergestellt ist.

10. Verfahren nach einem der vorhergehenden Ansprüche, **dadurch gekennzeichnet, dass** der Schritt für die Herstellung des Funktionselements eine Herstellung des Funktionselements (308) auf der Opferschicht (302) des starren Trägers (304) mit einer abfallenden (Englisch "top-down") oder steigenden (Englisch "bottom-up") Technik umfasst.

11. Verfahren nach Anspruch 10, **dadurch gekennzeichnet, dass** der Schritt für die Herstellung des Funktionselements (308) eine Herstellung, an dem Funktionselement, einer Form/eines Teilstücks umfasst, die/das dazu vorgesehen ist, von dem flexiblen Träger (310) umgeben zu sein und die/das mit der Opferschicht (302) und/oder dem starren Träger (304) einen Winkel kleiner oder gleich 90° aufweist, wenn das genannte Element auf die genannte Opferschicht (302) abgelegt wird.

## Claims

1. Method (100, 200) for the production of a flexible substrate (310) comprising at least one functional element (308) of micrometric or sub-micrometric dimensions, said method comprising the following steps:
- deposition (102) of a sacrificial layer (302) on a rigid, thus-termed master substrate (304),
- production (104) of said functional element (308) on said sacrificial layer (302),
- transfer (106, 108, 110) of said functional element (308) onto a flexible substrate (310), said transfer step comprising the following steps:
o production of the flexible substrate on said sacrificial layer, and
o removal (110) of said sacrificial layer (302);
**characterized in that** the sacrificial layer (302) comprises a molybdenum oxide.

2. Method according to claim 1, **characterized in that** the step of production of the flexible substrate comprises a step (106) during which a material intended to form the flexible substrate (310) is poured onto the surface of the rigid substrate (304) comprising the functional element (308).

3. Method according to claim 2, **characterized in that** it comprises a step (108) of hardening of the poured material through a cross-linking agent incorporated in said poured material.

4. Method according to any one of claims 2 or 3, **characterized in that** it comprises the addition (204) of a diluent to the material intended to form the flexible substrate (310) before pouring.

5. Method according to any one of the preceding claims, **characterized in that** the material from which the flexible substrate (310) is produced comprises silicone.

6. Method according to any one of the preceding claims, **characterized in that** the sacrificial layer (302) is molybdenum oxide.

7. Method according to any one of the preceding claims, **characterized in that** the step of removal of the sacrificial layer (302) is carried out with a solution comprising water and/or hydrogen peroxide.

8. Method according to any one of the preceding claims, **characterized in that** it comprises the addition (202) of a material compatible with molybdenum oxide in order to increase the melting temperature of the sacrificial layer (302).

9. Method according to any one of the preceding claims, **characterized in that** the rigid substrate (304) is produced from one or more materials chosen from silicon or glass.

10. Method according to any one of the preceding claims, **characterized in that** the step of production of the functional element comprises the production of said functional element (308) on the sacrificial layer (302) of the rigid substrate (304) by a top-down or bottom-up technique.

11. Method according to claim 10, **characterized in that** the step of production of the functional element (308) comprises the production on said functional element of a shape/part provided to be surrounded by the flexible substrate (310), and forming an angle of less than or equal to 90° with the sacrificial layer (302) and/or the rigid substrate (304) when said element is deposited on said sacrificial layer (302).
